Europäisches Patentamt

European Patent Office

Office européen des brevets

(19)

(11) Publication number: **0 477 822 A2**

# EUROPEAN PATENT APPLICATION

(21) Application number: **91116154.5**

(22) Date of filing: **23.09.91**

(51) Int. Cl.5: **H04N 7/13, H03H 17/06**

(30) Priority: **25.09.90 FI 904716**

(43) Date of publication of application:
**01.04.92 Bulletin 92/14**

(84) Designated Contracting States:
**DE ES FR GB IT NL SE**

(71) Applicant: **SALORA OY**
**Salorankatu 5-7**
**SF-241 00 Salo(FI)**

(72) Inventor: **Nieminen, Ari**
**Tasanteenraitti 8 F 12**
**SF-33610 Tampere(FI)**

Inventor: **Koivunen, Tero**
**Pispalan Valtatie 45 A 10**
**SF-33250 Tampere(FI)**
Inventor: **Lehtonen, Arto**
**Lukonmäenkatu 18 C 17**
**SF-33700 Tampere(FI)**

(74) Representative: **Liska, Horst, Dr.-Ing. et al**
**Patentanwälte H. Weickmann, Dr. K. Fincke,**
**F.A. Weickmann, B. Huber, Dr. H. Liska, Dr. J.**
**Prechtel Kopernikusstrasse 9 Postfach 86 08**
**20**
**W-8000 München 86(DE)**

(54) **Method for processing an incoming digital video signal which is in the form of a sampling train.**

(57) The invention relates to a method for improving the characteristics of a received video signal which is in the form of a sample train, the received video signal comprising only part of the original video signal. The known samples are arranged by using delay circuits (60, 70) into a sample space from the samples of which some are applied to a plurality of sub-interpolation means (30, 40, 50), in which sample candidates are simultaneously formed by using a fixed processing algorithm. A larger number of known samples are applied to a control means (10) perceiving the environment of the sample to be interpolated. It produces a control signal for the selection means (20) which selects, as the new interpolated sample, one of the outputs of the sub-interpolation means (30, 40, 50, 80), whereafter this is added to the sample train of the original video signal.

FIG. 3

Rank Xerox (UK) Business Services

EP 0 477 822 A2

The invention relates to a method which improves the properties of a received video signal which is in the form of a sampling train, the received video signal comprising only a portion of the original video signal.

A number of new television systems use a video signal the bandwidth of which is greater than the bandwidth used in current television systems. In addition to actual video information, also other information is transmitted in the same band, for example information regarding movement contained in the television picture being transmitted. In adopting new systems, at least at the initial stage it would be most economical to exploit the current systems as far as possible, and therefore it should be possible to transmit the video signal of these new systems by using the current channels reserved for television broadcasts. Therefore the bandwidth of the video signal of new systems should be limited in some manner to enable it to be transmitted via current channels.

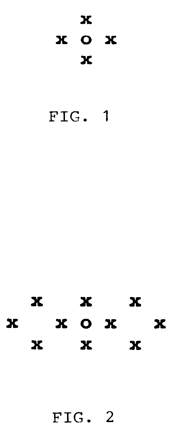

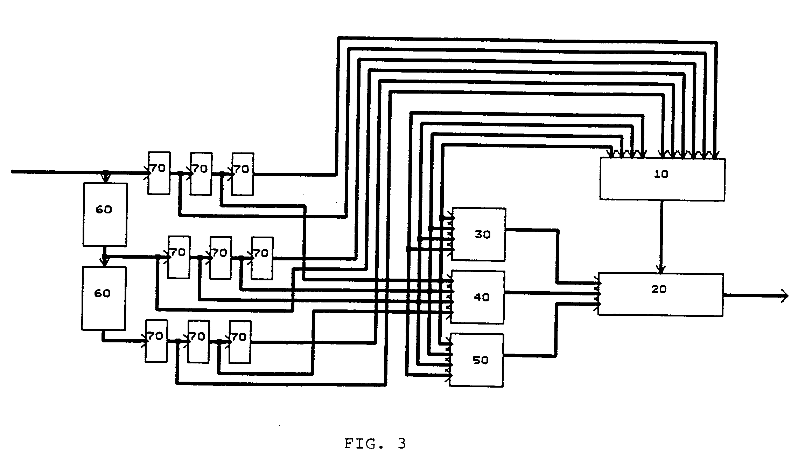

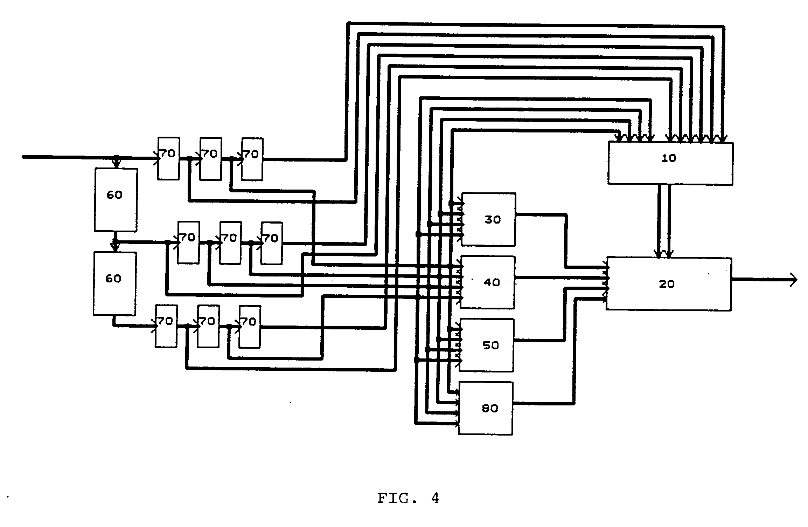

One such new television system is the Eureka95 HDTV system, in which also information on movement is transmitted in addition to the video signal. The video signal being transmitted is compressed with the help of this information on movement. In the transmitter the video signal is subsampled and, as a result, the bandwidth of the video signal transmitted will be compatible with the television channels currently in use. The received video signal must be processed in some manner in the receiver in order to obtain a signal with the original bandwidth. For this purpose, specific signal processing circuits, so-called interpolators, which carry out the necessary processing operation, are used in the receiver. The interpolator circuits process the sampled video signal, forming completely new samples between the received samples. The new samples are counted within each television picture. Figure 1 shows a so-called quincunx sampling pattern, which is a fragment of three successive lines. In it the samples (pixels) of adjacent lines are offset from each other in the vertical plane. The pixel to be interpolated is indicated by o, and the known, immediately neighboring pixels, obtained from the video signal, are indicated by x. In this sampling pattern there are four known neighboring samples. In a three-dimensional environment, pixels of the preceding field and the subsequent field are additionally counted among the neighboring samples. The new pixel o to be interpolated is calculated by some known method. It is clear that the quantity of the line and picture memory required by the interpolation is greater the greater is the number of samples in the time space that are included in the interpolation.

The quality of the picture formed in the receiver is largely dependent on the operation of the said interpolator circuits. In current systems, such as the Eureka95 HDTV system, the interpolator circuits used are fixed, and they operate according to the same selected method regardless of the content of the video signal being processed. Unsatisfactorily performed interpolation of the missing pixels is manifested in a lack of sharpness of the television picture shown on the receiver, incoherence of the details of the picture, and breaks or distortions of the picture. Especially areas on various lines and edges shown in the picture are difficult.

The present invention discloses a method by which the errors caused by prior known interpolation methods in a television picture can be reduced. This is done by improving the properties of the signal shown in the receiver, by using the interpolation method according to the invention, wherein the interpolation circuits process the received video signal according to an algorithm adapting to its changes.

The method according to the invention and the circuit for carrying out the method are characterized in what is stated in Claim 1.

The interpolator construction used for processing the video signal is not fixed; the interpolation method is selected within the circuit according to the picture information contained in the video signal which is the target of the processing. The method according to the invention thus includes a decision-making feature. This feature aims first at perceiving the environment of the pixel to be interpolated, by first defining the features contained in the environment, such as various shapes and the orientations of various lines and edges in greater detail. In other words, the aim is to find out whether the pixel to be formed is part of, for example, a horizontally, vertically or diagonally oriented edge. When the environment of the pixel has been perceived, the method and circuit most suitable for the calculation of the missing sample can be selected on the basis of the obtained information. The sampling pattern to be taken of a video signal may be the known quincunx pattern, either two-dimensional or three-dimensional.

The invention is described more clearly with reference to the accompanying figures, in which

Figure 1 depicts a known quincunx sampling pattern having four known neighboring pixels,

Figure 2 depicts an expanded sampling pattern used in one method according to the invention,

Figure 3 is a block diagram of the principle of the circuit to be used in the method, and

Figure 4 is a block diagram of the principle of another circuit used in the method.

In the method according to the invention, the sample, the pixel, to be interpolated in a sampled video signal is formed with the help of the known immediately neighboring samples. The quincunx sampling pattern shown in Figure 2, used in the method, has been expanded from the known pattern depicted in Figure 1 by taking into it more pixels from the neighborhood. In the figure, x is a known pixel and o is the pixel to be interpolated. In addition to the line containing the pixel to be interpolated there are thus needed pixel data from the previous line and the subsequent line. If it is desired to expand the pattern into a three-dimensional pattern, data are in this case needed on pixels of the preceding and subsequent picture fields. This example, however, is restricted to a two-dimensional case.

The pixel o to be interpolated, depicted in Figures 1 and 2, is calculated by using a circuit according to Figure 3 or 4. These circuits illustrate the application of the invention to an HDTV system. In a circuit according to Figure 3 or 4, the input signal In is a sub-sampled video signal which may, in the horizontal-vertical plane, be in accordance with the x-pixels of Figure 1 and Figure 2, i.e. the sampling includes every second pixel from each line, and the pixels of the lines are, according to the figures, offset from each other. The samples x of the input are thus derived from the same television picture.

In accordance with Figure 3, the sample space according to Figure 1 and Figure 2, i.e. the neighborhood, consisting of known pixels x, of the pixel to be interpolated, is formed in delay blocks 60, 70 from the sub-sampled signal train In. Delay block 60 is a sample-delay circuit, and delay block 70 is a line-delay circuit. From each output of the three topmost successive line-delay circuits 70 there are obtained the three known pixels of the topmost line of Figure 2, from the outputs of the middle three line-delay circuits 70 and the input of the chain there are obtained the four known pixels of the middle line, and from the chain of the lowest three line delay circuits 70 there is obtained, respectively, as from the topmost chain, the pixels of the lowest line of Figure 2. These samples, which thus represent the known pixels x of Figure 2, are applied to the control block 10.

Only some of the obtained pixel samples x of the sampling pattern according to Figure 2, i.e. those pixel samples which correspond to the closest neighbors of the pixel to be interpolated (i.e. the known x-pixels of Figure 1) are directed to sub-interpolation blocks 30, 40, and 50. Mean-value filtering is carried out in blocks 30 and 40, but on different pixel samples, and median filtering is carried out in block 50; in block 30 the targets of the mean-value filtering are the two known pixel samples of the middle line in the sampling pattern according to Figure 1, the targets of the mean-value filtering in block 40 are the pixels of the topmost and lowest lines in the sampling pattern according to Figure 1, and in block 50 a median filtering is carried out, the targets being all the four samples x according to Figure 1. Each of the sub-interpolation blocks produces a certain interpolated pixel candidate, which is taken to the selection block 20.

As mentioned above, samples representative of all x-pixels of Figure 2 arrive at the control block 10. From these samples the control block, implemented using logic circuits, is capable of perceiving the environment of the pixel to be interpolated, especially whether it is located in a horizontal, vertical or possibly diagonal edge area. The control block 10 provides information regarding this to the selection block 20, which on the basis of the information provided by the control block 10 selects the best candidate of the interpolated pixel candidates produced by blocks 30, 40, and 50. This selected pixel candidate, which now is the new sample, is then applied to the output of the selection block and is added to the original sample train, whereby a wide-band video signal is obtained, part of which has been interpolated in the receiver.

Another embodiment according to the invention is shown in Figure 4. This differs from the circuit of Figure 3 in that a block 80 has been added in parallel to blocks 30, 40 and 50. All of these blocks serve merely as switches, and one block always provides one neighboring pixel x of the pixel to be interpolated, as shown in Figure 1, i.e. the known samples depicted in Figure 1 of the quincunx sampling pattern are directed from these blocks to the control signal selection block. To the control block 10 there is added here a circuit carrying out the median operation and a circuit which calculates for its output some linear combination of its inputs. The selection block 20, under the control of the control signal of control block 10, selects as the new interpolated pixel one of its known immediately neighboring pixels or a pixel which has been obtained from a linear and/or median operation carried out on an expanded neighborhood (Figure 2).

**Claims**

1. A method for the interpolation of missing samples of an incoming digital video signal which is in the form of a sample train, there being formed by using delay means (60, 70) a sample space which comprises, in addition to the known samples directly adjacent to the new sample to be interpolated, also known samples from outside them, in which case the samples on successive lines and in a three-dimensional sample space are also from corresponding lines of the preceding and subsequent television pictures, **characterized** in that

- the known samples directly adjacent to the new sample to be interpolated are applied to a plurality of sub-interpolation means (30, 40, 50, 80), in which there are simultaneously formed new missing-sample candidates by using mean-value filtering and median filtering, the processing algorithm carried out by each means (30, 40, 50, 80) being fixed, and
- the formed sample candidates are directed to a selection means (20),
- the known samples directly adjacent to the new sample to be interpolated, and a number of known samples outside them, are applied to a control means (10) which perceives the environment of the sample to be interpolated and which, on the basis of the samples arriving in it, forms a control signal which is applied to the selection means (20),
- under the control of the control signal, the selection means (20) selects, as the new interpolated sample, one of the outputs of the sub-interpolation means (30, 40, 50, 80), whereafter this sample is added to the sample train of the original video signal.

2. A method according to Claim 1, **characterized** in that the sample space is two-dimensional and that the target of the mean-value filtering of the first interpolation means (30) consists of two known samples on the same line, the target of the second interpolation means (40) consists of the known samples of the line preceding the said line and the line subsequent to the said line, and the target of the median filtering of the third interpolation means (50) consists of all the said samples which are the target of the mean-value filtering.

3. A method according to Claim 1, **characterized** in that the sample space is two-dimensional and that the interpolation means (30, 40, 50, 80) serve as switches, the output of each being one of the known samples, and that the control means (10) includes means carrying out a median operation and/or a linear operation the target of which consists of all the known samples, in which case the selection means (20) selects, as the new interpolated sample, one of the outputs of the interpolation means (30, 40, 50, 80) serving as switching means or the output of the means carrying out the median operation and/or the linear operation.

4. A method according to any of the above claims, **characterized** in that the digital video signal is a video signal according to the Eureka95 HDTV system.

```
      x
   x  o  x
      x
```

FIG. 1

```
   x     x     x
x     x  o  x     x
   x     x     x
```

FIG. 2

FIG. 3

FIG. 4